# EUROPÄISCHE PATENTSCHRIFT

(11) **EP 1 250 713 B1**
(45) Veröffentlichungstag und Bekanntmachung des Hinweises auf die Patenterteilung: **08.10.2008**
(21) Anmeldenummer: 00993459.7
(22) Anmeldetag: 15.12.2000
(51) Int. Cl.: H01L 21/60, H01L 21/603, H01L 23/495

(54) **ANORDNUNG UND VERFAHREN ZUR KONTAKTIERUNG VON SCHALTKREISEN**
SYSTEM AND METHOD FOR CONTACTING SWITCHING CIRCUITS
DISPOSITIF ET PROCEDE DE LIAISON DE CIRCUITS DE COMMUTATION

(30) Priorität: 16.12.1999 EP 99125114
(43) Veröffentlichungstag der Anmeldung: 23.10.2002
(73) Patentinhaber: Infineon Technologies AG, 81669 München (DE)
(72) Erfinder: LEHNER, Rudolf, 93164 Laaber (DE)
(74) Vertreter: Schweiger, Martin
(86) Internationale Anmeldenummer: PCT/DE2000/004481
(87) Internationale Veröffentlichungsnummer: WO 2001/045159

(56) Entgegenhaltungen:
- EP-A- 0 338 232
- US-A- 4 215 359
- US-A- 5 393 705
- PATENT ABSTRACTS OF JAPAN vol. 010, no. 251 (E-432), 28. August 1986 (1986-08-28) & JP 61 079239 A (TOSHIBA CORP), 22. April 1986 (1986-04-22)
- PATENT ABSTRACTS OF JAPAN vol. 009, no. 075 (E-306), 4. April 1985 (1985-04-04) & JP 59 211240 A (TOSHIBA KK), 30. November 1984 (1984-11-30)

## Beschreibung

Die vorliegende Erfindung betrifft eine Anordnung und ein Verfahren zum Kontaktieren von Schaltkreisen.

Schaltkreise und integrierte Schaltungen werden zu ihrer Weiterverarbeitung mit einem Trägermaterial kontaktiert und in Gehäuse verpackt.

Das Kontaktieren mit einem Trägermaterial ist z.B. aus der Druckschrift GB-A-2177639 bekannt. Dort wird ein integrierter Schaltkreis mittels eines Ultraschall-Draht-Bonders (Wire-Bonder) mit einem Trägermaterial kontaktiert. Bei dem Trägermaterial handelt es sich in dieser Druckschrift um einen Leadframe. Eine weitere Druckschrift zu Wire-Bonding ist das US Patent 5,395,038.

Bei einem Wire-Bonder wird ein langer Draht (sogenannter Endlosdraht) verwendet, der sich auf einer Spule befindet. Das Verarbeitungsende des Endlosdrahtes wird durch die Bond-Maschine gefädelt und mit einer Kanüle an die zu kontaktierende Position herangefahren.

Beim sogenannten Ball-Bonden wird mittels Wärme und Ultraschall das Verarbeitungsende des Endlosdrahtes aufgeschmolzen und mit dem Kontaktpad des integrierten Schaltkreises, das sich auf dem integrierten Schaltkreis befindet, verbunden und bildet dabei eine Kugel, woraus der Name Ball-Bonden abgeleitet ist. Anschließend wird mit der Kanüle und dem darin befindlichen Bond-Draht eine Position auf dem Leadframe angefahren und der Bond-Draht wird mit dem Leadframe verbunden. Nun wird der Bond-Draht durchgetrennt und die Kanüle mit dem Bond-Draht fährt die nächste Position zur Bildung einer elektrischen Verbindung an.

Ein weiteres Verfahren zur Kontaktierung integrierter Schaltkreise ist das sogenannte Wedge-Wedge-Bonden. Dabei wird der Bond-Draht nicht aufgeschmolzen, sondern mit einem Stempel, der sich an einer Seite der Kanüle befindet, angepreßt bzw. angerieben.

Nachteilig an beiden Verfahren ist die Verwendung eines Bond-Drahtes, da dieser meist aus Gold hergestellt wird und daher teuer ist. Bei dicken Bond-Drähten ist der Goldpreis der größte Kostenfaktor, bei dünnen Bond-Drähten ist die Fertigungstechnik zur Erzeugung eines konformen, dünnen und homogenen Drahtes der größte Kostenfaktor.

Weiterhin ist es nachteilig, daß bei dem Wire-Bonden immer nur eine Bond-Verbindung zur Zeit in sukzessiver Abfolge angefertigt werden kann. Dies führt bei integrierten Schaltkreisen mit 1000 und mehr Kontakten zu einer langen Fertigungszeit, die die Kosten nach oben treibt.

Aus der JP59211240A ist ein Verfahren bekannt, bei dem zwei vorgefertigte Bond-Drähte von einer Saugvorrichtung gehalten zwischen einem Halbleiterchip und einem Flachleiterrahmen angeordnet und mittels Ultraschallenergie mit dem Halbleiterchip und dem Flachleiterrahmen verbunden werden.

Die lange Fertigungszeit kann mit der sogenannten Flip-Chip-Technik, die z.B. in dem US-Patent 4,887,758 beschrieben wird, verkürzt werden. Dazu wird ein Leadframe verwendet, dessen elektrische Leitungen so angeordnet sind, daß sie exakt bis zu den elektrischen Kontaktpads des integrierten Schaltkreises heranreichen. Dort werden die elektrischen Leitungen des Leadframes in einem Prozeß gleichzeitig auf alle Kontaktpads des integrierten Schaltkreises gedrückt und verbunden.

Die Flip-Chip-Technik hat allerdings den Nachteil, daß nur ein Chip mit dem Leadframe verbunden werden kann. Oftmals werden aber zwei oder mehr Einzelchips in einem Gehäuse verpackt und elektrisch kontaktiert. Die Flip-Chip-Technik ist dann nicht in der Lage, eine elektrische Verbindung zwischen zwei Chips in einem Gehäuse herzustellen.

Es ist die Aufgabe der vorliegenden Erfindung, eine Anordnung und ein Verfahren zur Kontaktierung von integrierten Schaltkreisen zu schaffen, das die gleichzeitige Kontaktierung aller elektrischen Kontakte ermöglicht.

Gelöst wird erfindungsgemäß die Aufgabe durch ein Verfahren zum Kontaktieren eines Schaltkreises mit den Schritten:
- Bilden von elektrischen Verbindern durch Einbringen von leitendem Material in eine Gussform, die mindestens aus zwei Formteilen besteht, wobei es sich bei einem Formteil um ein Setzelement handelt;
- Zerlegen der Gussform in ihre Formteile, wobei die elektrischen Verbinder an dem Setzelement verbleiben;
- Annähern des Setzelements mit den elektrischen Verbindern an einen Träger und einen neben dem Träger angeordneten Schaltkreis; danach
- Bonden, so dass die elektrischen Verbinder den Träger und den Schaltkreis elektrisch verbinden.

Der Vorteil der Erfindung besteht darin, daß mindestens zwei Bond-Verbindungen gleichzeitig in einem Bond-Prozeß den Schaltkreis mit dem Träger verbinden können. Bestenfalls können sogar alle Bond-Verbindungen gleichzeitig gebildet werden.

Ein weiterer Vorteil der Erfindung besteht in der Möglichkeit, elektrische Verbindungen zwischen zwei integrierten Schaltkreisen zu bilden, die in einem Gehäuse angeordnet sind. Ebenfalls ist es möglich, die Substrate zweier integrierter Schaltkreise übereinander anzuordnen und die elektrischen Verbindungen zwischen den integrierten Schaltkreisen zu bilden. Auch diese Bond-Prozesse sind parallel in einem Schritt ausführbar.

Besonders vorteilhaft an der Lösung der Aufgabe ist die Verwendung eines Gußverfahrens zur Bildung der Bond-Verbindungen. Dabei können Bond-Verbindungen, die große Ströme zu tragen haben, breiter und dicker ausgeführt werden, als diejenigen, die geringe Lasten zu tragen haben. Außerdem entfällt die kostenintensive Herstellung eines Bond-Drahtes.

Durch dieses Verfahren wird die gleichzeitige Kontaktierung von mehr als einem elektrischen Kontakt zwischen dem Träger und dem integrierten Schaltkreis oder zwischen zwei in einem Gehäuse zu verpackenden integrierten Schaltkreisen auf separaten Chips ermöglicht, wenn an dem Setzelement ein weiterer elektrischer Verbinder angeordnet ist.

Erfindungsgemäß ist das leitende Material in einer Gußform angeordnet, wobei ein Teil der Gußform aus dem Setzelement besteht. Durch diese Anordnung ist es möglich, die elektrischen Verbinder zwischen dem Schaltkreis und dem Träger in der Gußform zu gießen, und die Gußform später so zu öffnen, daß die elektrischen Verbinder vorerst an dem Setzelement verbleiben.

Im erfindungsgemäßen Verfahren wird die Gußform, die mindestens aus zwei Formteilen besteht, wobei es sich bei einem der Formteile um das Setzelement handelt, in ihre Formteile zerlegt, wobei die elektrischen Verbinder an dem Setzelement verbleiben. Durch dieses Verfahren wird das Gießen der elektrischen Verbinder und das Trennen der Gußform ermöglicht, wobei die elektrischen Verbinder direkt an den vorgesehenen Positionen in der Setzmatrix entstehen.

In einer besonders vorteilhaften Ausführung der Erfindung sind alle elektrischen Verbinder zwischen dem Schaltkreis und dem Träger an dem Setzelement angeordnet, so daß sie gleichzeitig in einem Bond-Prozeß den Schaltkreis und den Träger verbinden können. Durch dieses Verfahren wird eine enorme Zeitersparnis gegenüber Wire-Bonding erzielt, die sich in einer Kostenreduktion niederschlägt.

In einer weiteren vorteilhaften Ausprägung der erfindungsgemäßen Anordnung besteht das leitende Material zumindest teilweise aus Gold, Kupfer und/oder Aluminium. Dadurch ist es möglich, Metalle und metallische Legierungen zu verwenden, die nicht ausschließlich aus kostenintensivem Gold bestehen, sondern auch aus günstigerem hochleitfähigem Kupfer oder Aluminium hergestellt sind. Üblicherweise tritt bei dem Versuch, Bond-Drähte aus Kupfer herzustellen, das Problem auf, daß Kupfer oxidiert, bevor es eine elektrische Verbindung herstellen kann. Diesem Problem kann mit der Ummantelung von Kupfer mit Gold bei der Bond-Draht-Herstellung begegnet werden. Allerdings ist das Ummantelungsverfahren aufwendig und teuer.

Erfindungsgemäß wird die Aufgabe weiterhin durch die in Anspruch 5 angegebene Anordnung gelöst.

In einer weiteren vorteilhaften Ausprägung des erfindungsgemäßen Verfahrens werden die elektrischen Verbindungen zwischen dem Schaltkreis und dem Träger mittels Andrücken des Setzelements, mittels Ultraschall und/oder mittels Temperatur hergestellt. Dieses Verfahren hat den Vorteil, daß die elektrischen Verbinder direkt an den für sie vorgesehenen Positionen mit dem Schaltkreis und mit dem Träger verbunden werden.

In einer weiteren vorteilhaften Ausprägung des erfindungsgemäßen Verfahrens wird das Setzelement nach dem Bond-Prozeß von dem Schaltkreis und dem Träger entfernt. Bei diesem Prozeß verbleiben die elektrischen Verbinder zwischen dem Schaltkreis und dem Träger, und das Setzelement löst sich von den elektrischen Verbindern und wird von dem Schaltkreis und dem Träger entfernt.

Ausführungsbeispiele der vorliegenden Erfindung sind in den Zeichnungen dargestellt und nachfolgend näher erläutert.

Es zeigen:
- Figur 1: Ein Ausführungsbeispiel des Bond-Prozesses;
- Figur 2: Einen nach Figur 1 folgenden Schritt des Ausführungsbeispiels eines Bond-Prozesses;
- Figur 3: Eine Draufsicht auf eine Anordnung mit Schaltkreis, Träger und Bond-Verbindungen;
- Figur 4: Eine Gußform zur Herstellung von Bond-Verbindungen;
- Figur 5: Die Gußform aus Figur 4, wobei leitendes Material in die Gußform eingefüllt worden ist;
- Figur 6: Die Gußform nach Figur 5, wobei ein Verfahrensschritt dargestellt wird, der die Gussform öffnet;
- Figur 7: Einen Verfahrensschritt nach Figur 6, bei dem die elektrischen Verbinder an dem Schaltkreis und dem Träger angebracht werden;
- Figur 8: Ein weiterer Verfahrensschritt nach Figur 7, bei dem das Setzelement nach dem Bond-Prozeß von dem Schaltkreis und dem Träger entfernt wird.

In den Figuren bezeichnen gleiche Bezugszeichen gleiche oder funktionsgleiche Elemente.

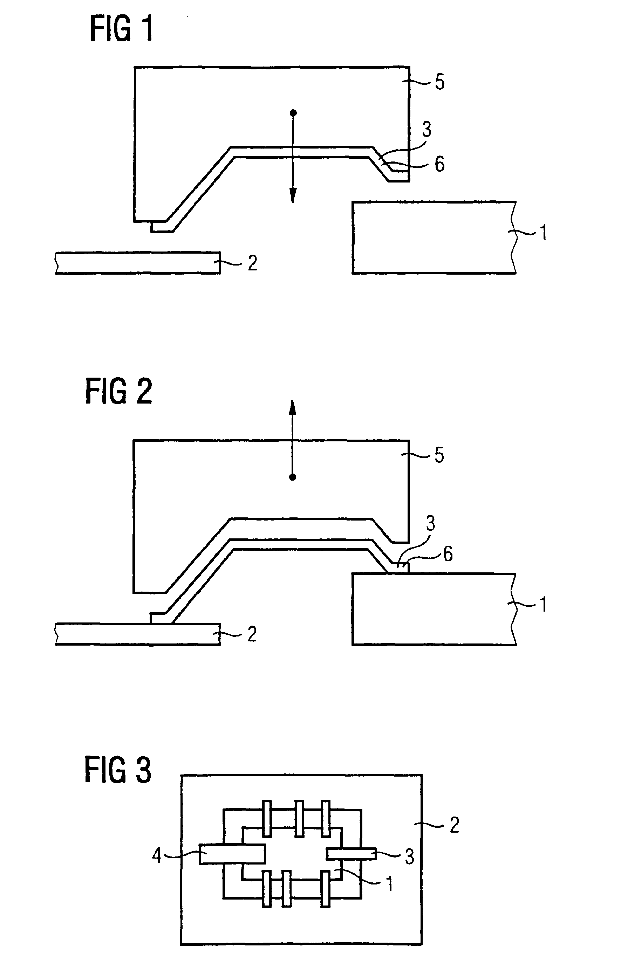

Mit Bezug auf Figur 1 ist eine erste Ausführungsform der Anordnung dargestellt. Der Schaltkreis 1 ist neben dem Träger 2 angeordnet. Bei dem Schaltkreis 1 kann es sich beispielsweise um einen auf einem Siliziumsubstrat hergestellten Schaltkreis handeln. Ebenso sind Substrate aus Galliumarsenid oder aus Dünnfilm-Materialien, wie sie beispielsweise zum Aufdampfen von TFT-(thin film transistor) Bauelementen verwendet werden, geeignet.

Bei dem Träger 2 handelt es sich beispielsweise um einen Leadframe. Ein Leadframe zeichnet sich durch leitfähige Bereiche aus, die zum Beispiel aus metallischen Leiterbahnen bestehen. Diese Leiterbahnen können zunächst noch verbunden sein, werden aber üblicherweise während der Herstellung eines gebondeten und gehäusten integrierten Schaltkreises voneinander getrennt.
Weiterhin kann es sich bei dem Träger 2 um einen Keramikträger handeln, auf dem mindestens ein integrierter Schaltkreis montiert werden kann. In oder auf dem Keramikträger, der üblicherweise ein isolierendes Grundmaterial darstellt, sind elektrisch leitende Bahnen angeordnet, die durch den Bond-Prozeß zumindest teilweise mit dem Schaltkreis 1 verbunden werden.
Ebenso ist es möglich, daß es sich bei dem Träger 2 um eine Leiterplatte handelt, die z.B. aus glasfaserverstärktem Kunststoff gebildet ist. Die Leiterplatte kann als mehrlagiger Schichtstapel aus leitenden und isolierenden Schichten mit Leiterbahnen und Kontakten ausgestaltet sein. All diesen Trägermaterialien ist aber gemeinsam, daß sie leitfähige Bereiche aufweisen, die mit dem Schaltkreis zu kontaktieren sind. Die leitfähigen Bereiche bestehen zum Beispiel aus Metallen wie Kupfer, Aluminium, etc., die optional verzinnt sind.

Des weiteren ist ein Setzelement 5 oberhalb des Trägers 2 und oberhalb des Schaltkreises angeordnet. An der Unterseite des Setzelements 5 befindet sich dabei ein elektrischer Verbinder 3, der aus einem leitenden Material 6 besteht. Bei dem leitenden Material 6 kann es sich beispielsweise um Gold, Kupfer oder Aluminium handeln. Auch sind Legierungen verwendbar, die Gold, Kupfer oder Aluminium enthalten. In Figur 1 ist mit dem Pfeil angedeutet, daß das Setzelement 5 an den Schaltkreis 1 und den Träger 2 angenähert wird.

Mit Bezug auf Figur 2 wird der elektrische Verbinder 3 mit dem Schaltkreis 1 und dem Träger 2 verbunden.

Der elektrische Verbinder 3 verbindet den Schaltkreis 1 und den Träger 2 auch nachdem das Setzelement 5, wie durch den Pfeil angedeutet, von dem Schaltkreis 1 und dem Träger 2 entfernt wird.

In Figur 3 ist in Draufsicht ein Schaltkreis 1, ein Träger 2, ein elektrischer Verbinder 3 zwischen dem Schaltkreis 1 und dem Träger 2 und ein weiterer elektrischer Verbinder 4 zwischen dem Schaltkreis 1 und dem Träger 2 dargestellt. Dabei können die einzelnen elektrischen Verbinder mit unterschiedlichem Durchmesser, unterschiedlicher Höhe und unterschiedlicher Breite ausgeführt werden. Es ist z.B. möglich, stromtragende Leitungen mit einem größeren Querschnitt auszubilden, als andere Leitungen, bei denen in diesem Fall die Kosten durch einen geringen Leitungsquerschnitt gesenkt werden können.

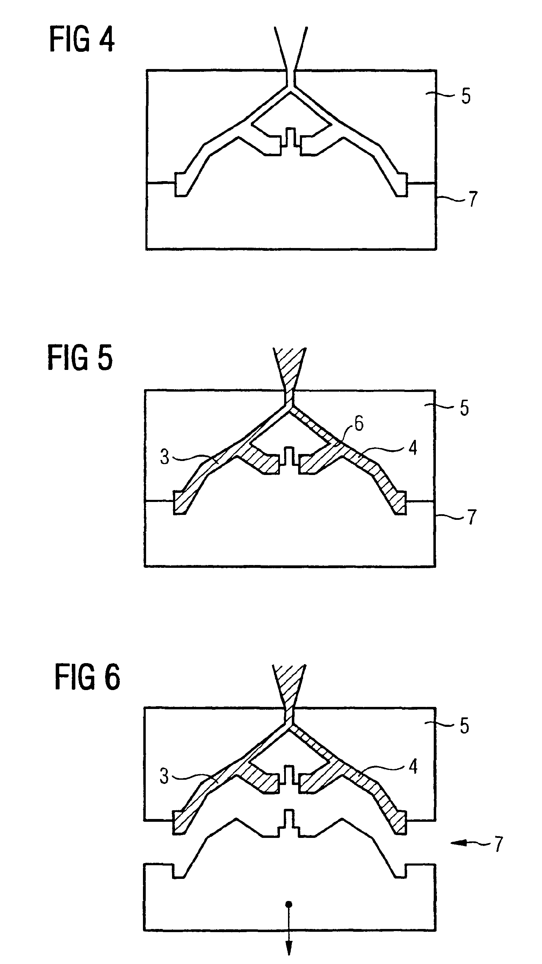

Mit Bezug auf Figur 4 wird ein Verfahren zur Herstellung eines ersten elektrischen Verbinders und des weiteren elektrischen Verbinders in einer Gußform 7 beschrieben. Die Gußform 7 besteht dabei teilweise aus dem Setzelement 5.

Mit Bezug auf Figur 5 wird das leitende Material 6 in den oben angedeuteten Trichter hineingefüllt und bildet so den elektrischen Verbinder 3 und den weiteren elektrischen Verbinder 4.

Mit Bezug auf Figur 6 wird die Gußform 7 geöffnet, so daß der elektrische Verbinder 3 und der weitere elektrische Verbinder 4 an dem Setzelement verbleiben.

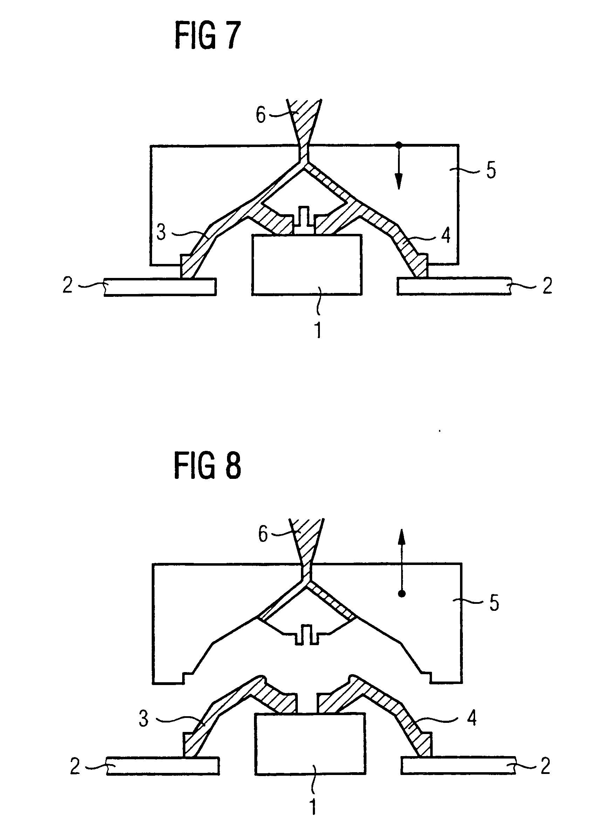

Mit Bezug auf Figur 7 wird nun das Setzelement 5 mit dem elektrischen Verbinder 3 und dem weiteren elektrischen Verbinder 4 auf den Schaltkreis 1 und den Träger 2 angedrückt und mittels Ultraschall, Druck und/oder Temperatur mit dem Schaltkreis 1 und dem Träger 2 verbunden.

Mit Bezug auf Figur 8 wird nach dem Bond-Prozeß das Setzelement von dem Schaltkreis 1 und dem Träger 2 entfernt, wobei der elektrische Verbinder 3 und der weitere elektrische Verbinder 4 als Bond-Verbindungen zwischen dem Schaltkreis 1 und dem Träger 2 verbleiben.

## Patentansprüche

1. Verfahren zum Kontaktieren eines Schaltkreises mit den Schritten:
- Giessen von elektrischen Verbindern (3) durch Einbringen von leitendem Material in eine Gussform (7), die mindestens aus zwei Formteilen besteht, wobei es sich bei einem Formteil um ein Setzelement (5) handelt;
- Zerlegen der Gussform (7) in ihre Formteile, wobei die elektrischen Verbinder (3) an dem Setzelement (5) verbleiben;
- Annähern des Setzelements (5) mit den elektrischen Verbindern (3) an einen Träger (2) und einen neben dem Träger (2) angeordneten Schaltkreis (1); danach
- Bonden, so dass die elektrischen Verbinder (3) den Träger (2) und den Schaltkreis (1) elektrisch verbinden.

2. Verfahren nach Anspruch 1,
**dadurch gekennzeichnet, daß**
alle elektrischen Verbindungen zwischen dem Schaltkreis (1) und dem Träger (2) gleichzeitig gebildet werden.

3. Verfahren nach Anspruch 1 oder 2,
**dadurch gekennzeichnet, daß**
die elektrischen Verbindungen zwischen dem Schaltkreis (1) und dem Träger (2) mittels Andrücken des Setzelements (5) und/oder mittels Ultraschall und/oder mittels Wärme hergestellt werden.

4. Verfahren nach einem der Ansprüche 1 bis 3,
**dadurch gekennzeichnet, daß**
das Setzelement (5) nach dem Bond-Prozeß von dem Schaltkreis (1) und dem Träger (2) entfernt wird.

5. Anordnung zum Kontaktieren von Schaltkreisen nach einem der voranstehenden Verfahren mit:
- einem Schaltkreis (1);
- einem Träger (2), der neben dem Schaltkreis (1) angeordnet ist, wobei gegossene elektrische Verbinder (3) aus einem leitenden Material (6) an einem Setzelement angeordnet sind, das ein Formteil einer Gussform ist, und den Schaltkreis (1) mit dem Träger (2) verbinden.

6. Anordnung nach Anspruch 5,
**dadurch gekennzeichnet, daß**
alle elektrischen Verbinder(3) zwischen dem Schaltkreis (1) und dem Träger (2) gegossene elektrische Verbinder sind, die an dem Setzelement angeordnet sind.

7. Anordnung nach einem der Ansprüche 5 oder 6,
**dadurch gekennzeichnet, daß**
das leitende Material (6) zumindest teilweise aus Gold und/oder Kupfer und/oder Aluminium besteht.

## Claims

1. Method for contacting a switching circuit comprising the steps of:
- casting electrical connectors (3) by introducing conductive material into a casting mould (7), which comprises at least two mould parts, one mould part being a setting element (5);
- disassembling the casting mould (7) into its mould parts, the electrical connectors (3) remaining on the setting element (5);
- bringing the setting element (5) with the electrical connectors (3) up close to a support (2) and a circuit (1) arranged next to the support (2); and then
- bonding, so that the electrical connectors (3) electrically connect the support (2) and the circuit (1).

2. Method according to Claim 1, **characterized in that** all the electrical connections between the circuit (1) and the support (2) are formed at the same time.

3. Method according to Claim 1 or 2, **characterized in that** the electrical connections between the circuit (1) and the support (2) are established by means of pressing the setting element (5) into place and/or by means of ultrasound and/or by means of heat.

4. Method according to one of Claims 1 to 3, **characterized in that,** after the bonding process, the setting element (5) is removed from the circuit (1) and the support (2).

5. Arrangement for contacting circuits by one of the above methods, comprising:
- a circuit (1);
- a support (2), which is arranged next to the circuit (1), with cast electrical connectors (3) of a conducting material (6) being arranged on the setting element, which is a mould part of a casting mould, and connecting the circuit (1) to the support (2).

6. Arrangement according to Claim 5, **characterized in that** all the electrical connectors (3) between the circuit (1) and the support (2) are cast electrical connectors which are arranged on the setting element.

7. Arrangement according to either of Claims 5 and 6, **characterized in that** the conducting material (6) consists at least partially of gold and/or copper and/or aluminium.

## Revendications

1. Procédé de mise en contact d'un circuit, lequel procédé comprend les étapes qui consistent à :
- mouler des connecteurs électriques (3) par apport d'un matériau conducteur dans un moule (7) constitué d'au moins deux pièces de forme dont l'une des pièces de forme est un élément de positionnement (5),
- séparer le moule (7) en ses pièces de forme, les connecteurs électriques (3) restant à l'élément de positionnement (5),
- rapprocher l'élément de positionnement (5) qui présente les connecteurs électriques (3) d'un support (2) et d'un circuit (1) disposé à côté du support (2) et ensuite,
- former la liaison de telle sorte que les connecteurs électriques (3) relient électriquement le support (2) et le circuit (1).

2. Procédé selon la revendication 1, **caractérisé en ce que** toutes les liaisons électriques entre le circuit (1) et le support (2) sont réalisées simultanément.

3. Procédé selon l'une des revendications 1 ou 2, **caractérisé en ce que** les liaisons électriques entre le circuit (1) et le support (2) sont formées en appuyant l'élément de positionnement (5) et/ou par ultrasons et/ou par chaleur.

4. Procédé selon l'une des revendications 1 à 3, **caractérisé en ce qu'**après l'opération de formation de la liaison, l'élément de positionnement (5) est retiré du circuit (1) et du support (2).

5. Arrangement de mise en contact de circuits selon l'un des procédés précédents, qui présente :
- un circuit (1),
- un support (2) disposé à côté du circuit (1), des connecteurs électriques moulés (3) en matériau conducteur (6) étant disposés à un élément de positionnement qui forme une pièce de forme d'un moule et reliant le circuit (1) au support (2).

6. Arrangement selon la revendication 5, **caractérisé en ce que** tous les connecteurs électriques (3) disposés entre le circuit (1) et le support (2) sont des connecteurs électriques moulés disposés à l'élément de positionnement.

7. Arrangement selon l'une des revendications 5 ou 6, **caractérisé en ce que** le matériau conducteur (6) est constitué au moins en partie d'or et/ou de cuivre et/ou d'aluminium.
